# EUROPÄISCHE PATENTSCHRIFT

(11) **EP 0 370 188 B1**
(45) Veröffentlichungstag und Bekanntmachung des Hinweises auf die Patenterteilung: **15.07.1998**
(21) Anmeldenummer: 89116747.0
(22) Anmeldetag: 11.09.1989
(51) Int. Cl.: H01L 21/68, B25J 21/00, H01J 37/18, G11B 7/26, B01J 3/00

(54) **Transporteinrichtung und Vakuumkammer mit einer solchen Einrichtung sowie Verfahren zum Beschicken und Entleeren einer Bearbeitungskammer**
Transport device and vacuum chamber with such a device and process for loading and unloading a processing chamber
Dispositif de transport et enceinte à vide avec un tel dispositif et procédé pour le chargement et le déchargement d'une enceinte de travail

(30) Priorität: 17.11.1988 CH 4267/88
(43) Veröffentlichungstag der Anmeldung: 30.05.1990
(73) Patentinhaber: BALZERS AKTIENGESELLSCHAFT, 9496 Balzers (LI)
(72) Erfinder: Fischer, Heinrich, FL-9495 Triesen (LI); Strasser, Gregor, Dr., FL-9490 Vaduz (LI); Zöhrer, Gerald, CH-9476 Weite (CH); Schertler, Roman, At-6922 Wolfurt (AT)
(74) Vertreter: Troesch, Jacques J., Dr. sc. nat.

(56) Entgegenhaltungen:
- EP-A- 0 242 997
- EP-A- 0 246 798
- DE-C- 3 801 998
- GB-A- 2 143 494
- US-A- 4 553 069
- US-A- 4 670 126

## Beschreibung

Die vorliegende Erfindung betrifft eine Transporteinrichtung nach dem Oberbegriff von Anspruch 1.

Im weiteren betrifft die vorliegende Erfindung auch eine Vakuumkammer mit einer genannten Transporteinrichtung nach Anspruch 9, eine Verwendung der Transporteinrichtung bzw. der Vakuumkammer nach Anspruch 10 sowie ein Beschickungsverfahren nach Anspruch 13.

Aus der EP-A-0 242 997 ist eine Transporteinrichtung bekannt, um Werkstücke von einem Werkstückmagazin mit einer ersten Umgebung in eine Behandlungskammer, wie eine Vakuumkammer, mit einer zweiten Umgebung, von dort in eine dritte Umgebung etc. überzuführen. Die Transporteinrichtung von einer Kammer in die andere umfasst dabei einen zweiarmigen Hebel, der zwischen den genannten Kammern angeordnet ist und in beide eingeklappt werden kann. Dieser Hebel ist integriert in einer Dichtventilanordnung, mit deren Hilfe die Kammern voneinander dichtend getrennt bzw. miteinander verbunden werden können. Diese dichtende Ventilanordnung ist ähnlich einem Tor ausgebildet, so dass entweder die beiden betroffenen Kammern und somit ihre Atmosphären verbunden sind oder voneinander getrennt sind.

Eine solche Transporteinrichtung hat den Nachteil, dass mit jeder Hebelausschwenkung in eine der beiden betroffenen Kammern die beiden erwähnten Kammern verbunden werden, womit sich ein Ausgleich der jeweiligen Atmosphären einstellt. Muss in der einen der Kammern mit in engen Toleranzen gehaltener Arbeitsatmosphäre gearbeitet werden, so bedingt dieses Vorgehen, dass nach jedem, die beiden erwähnten Kammern betreffenden Transportvorgang die erwähnte Kammer neu konditioniert werden muss.

Somit ist die hier dargestellte Transporteinrichtung nicht in der Lage, ein Werkstück ohne Zwischenablage aus einer ersten Umgebung in eine zweite zu fördern, im wesentlichen, ohne dass die eine Umgebung die andere beeinflusste.

Im weiteren ist es aus der EP-A-0 246 798 bekannt, innerhalb seriell aneinander geschalteter Behandlungskammern je Transporthebel vorzusehen, wobei ein Transporthebel in einer betrachteten Kammer jeweils in diese besagte sowie, übergreifend, in die nächste einwirkt. Auch hier sind zwei betrachtete Bearbeitungskammern bei einem sie betteffenden Transportvorgang verbunden, so dass darnach die jeweiligen Kammern wegen ihrer Atmosphärenbeeinflussung durch benachbarte Kammern neu konditioniert werden müssen, wenn die Bearbeitungsatmosphäre jeder der betrachteten Kammern innerhalb enger Toleranzen aufrechterhalten werden muss und die Atmosphären in den betrachteten Kammern unterschiedlich sind.

Desgleichen ist es aus der US-A-4 553 069 bekannt, in einer Vakuumkammer einen storchenschnabelähnlichen, mehrarmigen Transporthebelmechanismus vorzusehen. Zur Entnahme zu behandelnder Werkstücke, wie von Wafern, aus einem Magazin wird aus der Vakuumkammer durch ein dann geöffnetes Schlitzventil in das Magazin eingegriffen und damit wiederum zwischen Magazin und Vakuumkammer eine Verbindung erstellt, welche bedingt, dass bei heiklen und in engen Toleranzen zu haltenden Vakuumverhältnissen während der Bearbeitung, nach einem Transportvorgang, die Vakuumkammer neu zu konditionieren ist.

Zudem ergibt das Vorsehen des Transportarmes mit zugeordneten Organen in der Vakuumkammer, wie auch übrigens gemäss der EP-A-0 246 798, ein relativ grosses Kammernvolumen mit dem entsprechend zu treibenden Aufwand, was Pumpleistung und Konditionierungszeiten anbelangt: Das für die Transporteinrichtung bereitgestellte Volumen in der Vakuumkammer muss mitkonditioniert werden.

Auch aus der US-A-4 670 126 ist es bekannt, in einer Zwischenkammer zu mehreren Bearbeitungskammern einen mehrarmigen Transporthebel vorzusehen, der wahlweise in eine der vorgesehenen, angeschlossenen Bearbeitungskammern eingreifen kann, über Tore mit schlitzventilartigen Verschlüssen. Der mehrarmige Transporthebel mit seinen Ausfahrmöglichkeiten in die angeschlossenen Kammern ergibt ein relativ grosses Volumen der Zwischenkammer, welch letztere bei jedem Transportvorgang in eine der angeschlossenen Bearbeitungskammern mit letzterer kommuniziert, so dass eine gegenseitige Atmosphärenbeeinflussung stattfindet und mithin einerseits, nach einem jeweiligen Transportvorgang, die entsprechende Bearbeitungskammer neu konditioniert werden muss, ebenso wie allenfalls die Zwischenkammer.

Aus der US-A-4 733 746 ist es weiter bekannt, eine Vakuumbearbeitungskammer beidseitig über zwei Vakuumvorkammern zu beschicken, mittels einer nicht weiter dargestellten Transporteinrichtung.

Dabei ist im weiteren ein spezieller Uebergabezyklus beschrieben, von einer Vorkammer in die Vakuumkammer und in die nächste Vorkammer, wobei jeweils alle drei Kammern miteinander verbunden werden, womit relativ grosse Volumina, nämlich diejenigen der Zwischenkammern, auf die Vakuumkammer Einfluss nehmen.

Nun ist aus der GB-A-2 143 494 eine Transporteinrichtung bekannt, bestehend aus einer Schleusenkammer, worin ein zweiarmiger Schwenkhebel im wesentlichen zentral in der Kammer gelagert ist und beidseits aus konventionellen Schlitzventilen ausfahrbar ist. Die beiden Arme des Transporthebels werden getrennt angetrieben, was die Ansteuerung einer praktisch beliebigen Kurvenbahn der endständigen Aufnahmepartie des Hebels ermöglicht. Anderseits ist diese Transporteinrichtung in dem Sinne nachteilig, dass der Antrieb und die entsprechenden Durchführungen für die beiden Hebelarme bezüglich Vakuumdichtheit ausserordentlich kompliziert sind und dass die Kammer relativ voluminös ist, was sich negativ auf zu installierende Pumpaggregate bzw. -leistung und -zeiten niederschlägt.

Im weiteren wird auf die EP-A-0 291 690 verwiesen.

Die vorliegende Erfindung setzt sich zum Ziel, eine Transporteinrichtung der in der GB-A-2 143 494 genannten Art so weiterzubilden, dass nur minimale Volumina konditioniert werden müssen, nach einem Transportvorgang von einer in die andere Umgebung, was die Zykluszeit wesentlich reduziert, und setzt sich im weiteren die Aufgabe, diese Zykluszeit durch einen gezielten Transportrhythmus zu optimieren.

Zu diesem Zweck zeichnet sich die erfindungsgemässe Transporteinrichtung nach dem Wortlaut von Anspruch 1 aus, das erfindungsgemässe Verfahren nach dem Wortlaut von Anspruch 13.

Anders als bei bekannten Transporteinrichtungen, bei welchen Bearbeitungskammern bei Transportzyklen miteinander kommunizieren, wird von einem Verfahren gemäss der US-A-4 733 746 ausgegangen, gemäss welcher, beispielsweise bei Vakuumbehandlungsprozessen, die Werkstücke mittels Schleusen in eine Vakuumkammer eingebracht werden. Dabei umfassen die Transporteinrichtungen Schleusen, die es ermöglichen, ein Werkstück in eine solche Kammer mit Behandlungsumgebung einzubringen und dabei die in der Kammer herrschende Behandlungsumgebung von derjenigen ausserhalb der Kammer zu trennen.

Nach bekannter Funktionsweise derartiger Schleusen werden sie hierzu erst einseitig geöffnet, mit dem Transporthebel wird ein Werkstück in die Schleuse eingebracht, darnach wird die Schleuse geschlossen und der Raum der Schleusenkammer auf die Umgebungsverhältnisse in der Behandlungskammer angepasst. Muss dabei verhindert werden, dass Einflüsse der Umgebung ausserhalb der Behandlungskammer auf die Verhältnisse innerhalb der Behandlungskammer Einfluss nehmen, so wird die Schleusenkammer beidseits geschlossen, evakuiert und auf dieselben Umgebungsverhältnisse gebracht, die in der Behandlungskammer herrschen, bevor nachmals die Schleuse gegen die erwähnte Behandlungskammer hin geöffnet wird. Dann wird das Werkstück mit der Transporteinrichtung in die Behandlungskammer eingebracht. Kann toleriert werden, dass das in der Schleusenkammer eingeschlossene Gasvolumen die Verhältnisse in der Behandlungskammer beeinflusst, so wird, nachdem das Werkstück in die Kammer eingebracht worden ist, die Schleusenkammer lediglich gegen die Behandlungskammer hin geöffnet und das Werkstück in letztere eingebracht.

In beiden Fällen ist dabei dem Volumen der Schleusenkammer Beachtung zu schenken: Während im ersten Fall die Zykluszeit und die vorzusehenden Evakuierungs- und Konditionierungsaggregate massgebend vom Schleusenkammervolumen, welches zu evakuieren und zu konditionieren ist, abhängen, beeinflusst im zweiten Fall das Schleusenkammervolumen das Mass, mit welchem die Verhältnisse in der Behandlungskammer durch das in der Schleusenkammer gefangene Volumen beeinflusst werden.

Dadurch, dass bei der an der erfindungsgemässen Transporteinrichtung vorgesehenen Schleusenkammer ein in deren Randbereich schwenkgelagerter Hebel vorgesehen ist, die Schleusenkammer beidseitig des Schwenklagers für den Hebel Schleusentore aufweist, derart, dass der Hebel beidseitig mit seiner dem Schwenklager abgekehrten Partie bei jeweils geöffnetem Schleusentor aus der Kammer ausschwenkbar ist, wird erreicht, dass bei vorgegebener Schleusenkammerausdehnung mit diesem Hebel der grösstmögliche Schwenkweg durchlaufen werden kann, womit, umgekehrt betrachtet, bei gegebenem Schwenkweg ein minimales Schleusenkammervolumen erreicht wird.

Dadurch, dass die Transporteinrichtung einen in der Schleusenkammer derart schwenkgelagerten Hebel umfasst, ist m.a.W. die Möglichkeit gegeben, das Kammervolumen durch die bezüglich des Schwenklagers azimutale Ausdehnung des Hebels zu begrenzen und anderseits den durch die Transporteinrichtung zu überstreichenden Transportweg durch die Radialausdehnung des Hebels zu geben. Wie erwähnt, ergibt sich somit die Möglichkeit, das Kammervolumen weitgehend unabhängig von der zu durchlaufenden Transportstrecke auszubilden.

Die Schleusentore werden dabei bevorzugterweise betrachtet in Richtung der Schwenklagerachse, so angeordnet, dass sie eine Fläche beranden, die im wesentlichen gegeben ist durch die Form des Hebels und eines zu fördernden, in die Schleusenkammer eingeholten Werkstückes. Damit wird diese Fläche auf das minimal erforderliche Ausmass begrenzt.

Da zur Freigabe der kreisförmigen Schwenkbahn des Hebels ausgedehnte Schleusentore vorzusehen sind, wird gemäss Wortlaut von Anspruch 2 weiter vorgeschlagen, die Schleusentore durch Schlitzventile auszubilden vorzugsweise weiter nach Anspruch 3 als Schlitschieber. Hierzu können z.B. Schlitz-Ventile der Firma V.A.T. eingesetzt werden.

Grundsätzlich handelt es sich dabei um Schlitzventile, bei welchen der Ventilschieber torartig nur in einer Richtung auf- und abbewegt wird, ohne dass weiter eine senkrecht zur Schliess- bzw. Oeffnungsbewegung vorgenommene zweite Bewegung nötig wäre, um die Dichtheit zu erstellen bzw. zu lösen. Derartige Ventile weisen mithin bezüglich Standzeiten und insbesondere bezüglich Abriebminimalisierung gegenüber "Zweibewegungsschlitzventilen" ganz wesentliche Vorteile auf. Die erfindungsgemäss eingesetzten Ventile sind beispielsweise auch in der DE-OS 38 01 998 beschrieben.

Um nun im weiteren den Arbeitszyklus für ein in der Behandlungskammer, insbesondere Vakuumkammer, zu behandelndes Werkstück zu verkürzen, wird gemäss Wortlaut von Anspruch 4 vorgeschlagen, ein Paar Schleusenkammern der genannten Art vorzusehen und diese im Gegentakt zu betreiben. Dies heisst, dass, wenn der Transporthebel der einen Schleusenkammer in die Aussenumgebung bezüglich der Behandlungskammer wirkt, der Transporthebel der andern Schleusenkammer in der Behandlungskammer steht, und dass gleichzeitig beide Transporthebel in die entsprechenden Schleusenkammern rückgeholt sind, die eine auf die Verhältnisse ausserhalb der Behandlungskammer gebracht wird, während die andere gleichzeitig auf die Verhältnisse entsprechend dem Innern der Behandlungskammer gebracht wird. Dadurch wird die Durchlaufzeit für Werkstücke durch den Behandlungsprozess verkürzt.

In vielen Fällen ist es im weiteren anzustreben, die laufend der Behandlungskammer zuzuführenden Werkstükke nicht an zwei örtlich getrennten Aufnahmepositionen, je für die vorgesehenen Transporteinrichtungen, zuführen zu müssen, sondern mit beiden Transporteinrichtungen Werkstücke an derselben ausserhalb der Behandlungskammer liegenden Position aufnehmen zu können und/oder innerhalb der Behandlungskammer mit beiden Transporteinrichtungen die jeweiligen Werkstücke in dieselbe Behandlungsposition bringen zu können.

Dies ist bei einer weiteren erfindungsgemässen Ausbildung der vorgesehenen Transporteinrichtung ohne weiteres dadurch möglich, dass sich gemäss Wortlaut von Anspruch 5 die durch die Hebel überstrichenen Kreisbahnflächen mindestens in der einen der beiden Umgebungen überlappen.

Wird dabei angestrebt, sowohl in der Behandlungskammer mit beiden Transporteinrichtungen dieselbe Behandlungsposition beschicken zu können wie auch, ausserhalb der Behandlungskammer, mit den beiden Transporteinrichtungen ab bzw. auf derselben Beschickungsstation bzw. Entnahmestation wirken zu können, so wird vorgeschlagen, gemäss Wortlaut von Anspruch 6 vorzugehen, indem sich die durch die Hebel überstrichenen Kreisbahnflächen in beiden Umgebungen überlappen.

Dies wird bevorzugterweise gemäss Wortlaut von Anspruch 7 dadurch erreicht, dass die beiden Schleusenkammern so aneinanderliegen, dass die Schwenklager einander benachbart sind.

Im weiteren wird gemäss Wortlaut von Anspruch 8 eine Vakuumkammer mit einer wie erwähnt ausgebildeten Transporteinrichtung vorgeschlagen. Eine solche Vakuumkammer eignet sich insbesondere für die Beschichtung von Memory Discs, bei welcher in diese erfindungsgemässe Vakuumkammer mit den erfindungsgemäss vorgesehenen Schleusenkammern Grundkörper zur Vakuumabscheidung von Metallen, wie z.B. von Aluminium oder Aluminiumlegierungen, eingebracht werden. Mit einer derartigen erfindungsgemässen Vakuumkammer wird eine der Produktionsstufen der Gesamtproduktionslinie wesentlich schneller, womit, in Anbetracht, dass die Vakuumprozessstufe in der Produktionsstufenkette bis anhin eine der langsameren war, die Gesamtherstellungszeit verkürzt wird. Durch die erwähnte Möglichkeit, mit der erfindungsgemässen Transporteinrichtung jeweils ausserhalb der Vakuumkammer und innerhalb der Behandlungskammer dieselben Uebernahme- bzw. Abgabe-bzw. Behandlungsstellen zu bedienen, wird die Handhabung der zugeförderten Discs als Werkstücke und werden damit die vorzusehenden Beladungsgeräte besonders einfach und kostengünstig, indem insbesondere für die Kammerbeschickungen die Discs an einer einzigen Stelle frei zugänglich dem jeweiligen Transporthebel übergeben werden können.

Im weiteren erlaubt das erfindungsgemäss vorgeschlagene Konzept, gerade bei der Memory-Disc-Produktion, dass ohne Reduzierung der Zykluszeiten jeweils nur ein oder zwei Werkstücke, z.B. CD's, von der Uebernahmestelle in den Vakuumbehandlungsprozess eingeführt sind, so dass jederzeit bei Fehlfunktion des Gesamtprozesses ein Anhalten der Anlage möglich ist, ohne dass bereits eine grosse Zahl von Discs im Vakuumbeschichtungsprozess involviert wäre und als Ausschuss bei Wiederstart der Anlage auszuscheiden wäre bzw. gewartet werden müsste, bis viele, bei Anhalten der Anlage bereits im Behandlungsprozess involvierte Werkstücke den Vakuumbehandlungsprozess, d.h. die Vakuumkammer verlassen haben, um den Gesamtprozess wieder zu starten.

Durch die höchst einfache Ausbildung der Transporteinrichtungen mit Schwenkhebel ist es ohne weiteres möglich, das Werkstückformat zu wechseln, so, insbesondere bei der Memory-Disc-Produktion, die zwei gängigen Formate von beispielsweise 80 und 120 mm Durchmesser oder grösser zu wechseln.

Bei der erfindungsgemässen Transporteinrichtung ist es in manchen Fällen erwünscht, die durch die beiden Hebel an den Schleusenkammern in die eine Umgebung, insbesondere die Behandlungsumgebung, eingebrachten Werkstücke dort nicht nur an derselben Position, sondern in dieselbe absolute Ausrichtung zu bringen. Es sei nämlich betont, dass im Zusammenhang mit der vorliegenden Erfindung unter Werkstück nicht nur ein einteiliges Teil zu verstehen ist, sondern eine mit einem der jeweiligen Hebel gemeinsam geförderte Einheit, die durchaus aus mehreren einzelnen, gleichzeitig zu behandelnden Teilen bestehen kann.

Die Erfindung wird anschliessend beispielsweise anhand von Figuren erläutert.

Es zeigen:
- Fig. 1: schematisch eine erfindungsgemässe Schleusenkammer mit ihrem grundsätzlichen, erfindungsgemässen Konzept,
- Fig. 2: in Darstellung analog zu Fig. 1 den schematischen Aufbau einer erfindungsgemässen Schleusenkammer bei Minimalisierung des Schleusenkammervolumens,
- Fig. 3: schematisch eine erfindungsgemässe Schleusenkammeranordnung mit zwei erfindungsgemässen Schleusenkammern, wobei sich die Bewegungsbahnen der Transporteinrichtungen in der einen der beiden durch die Schleusenkammern beschickten Umgebungen überlappen,
- Fig. 4a bis 4f: schematisch eine erfindungsgemässe Vakuumkammer mit einer aus erfindungsgemässen Schleusenkammern bestehenden Schleusenkammeranordnung für die Vakuumbeschichtung von Memory Discs, z.B. CD's,
- Fig. 5: schematisch eine erfindungsgemässe Schleusenkammeranordnung, um Werkstücke mit derselben Ausrichtung in eine Behandlungsumgebung einzubringen.

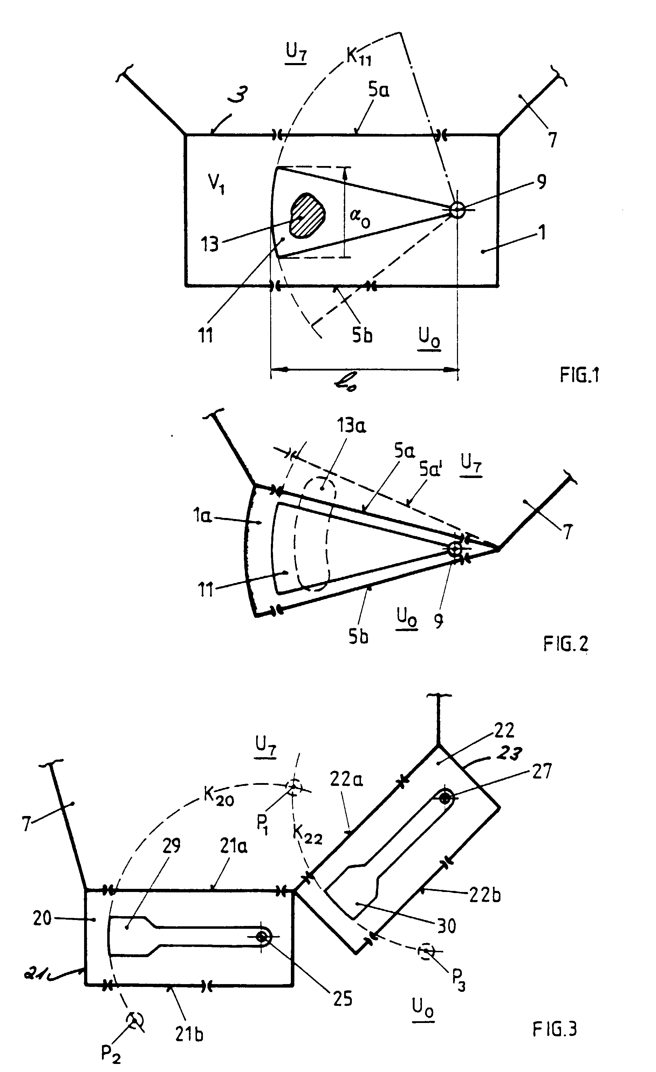

In Fig. 1 ist schematisch eine erfindungsgemässe Schleusenkammer 1 dargestellt. Sie umfasst eine dichte Berandung 3, woran zwei Schleusentore 5a und 5b in nachmals zu beschreibender Art und Weise vorgesehen sind. Das Schleusentor 5a trennt das Innere der Schleusenkammer 1 mit dem Volumen V₁ von ihrer einen Umgebung U₇ ab, welche in einer nur teilweise eingetragenen Behandlungskammer 7 herrscht. Bei der Behandlungskammer 7 kann es sich insbesondere um eine Vakuumbehandlungskammer handeln. Das zweite Schleusentor 5b trennt das Innere der Schleusenkammer 1 gegen ihre zweite Umgebung U₀ ab, beispielsweise die Aussenumgebung der Behandlungskammer 7. In der Schleusenkammer 1 ist, um eine Achse 9 schwenkbeweglich gelagert, als Transporteinrichtung, ein Hebel 11 angeordnet, der gemäss Fig. 1, als eines der vielen möglichen Ausführungsbeispiele, kreissektorförmig ausgebildet ist.

Durch Schwenken um die Achse 9 überstreicht der Hebel 11 eine gestrichelt bei K₁₁ eingezeichnete Kreisfläche, um ein Werkstück 13, welches vorzugsweise an dem der Schwenkachse 9 abgelegten Ende des Hebels 11 transportiert wird, zwischen der Umgebung U₇ und der Umgebung U₀ hin bzw. her zu fördern. Je nach dem Mass, mit welchem der Hebel 11 in die Umgebung U₇ bzw. U₀ ausschwenkbar sein soll, um das Werkstück 13 in den entsprechenden Umgebungen an vorgegebene Positionen zu fördern, werden die Schleusentore 5a bzw. 5b länger oder kürzer dimensioniert.

In Fig. 1 ist eine kleinere Ausschwenkbewegung in die Umgebung U₀ erfordert als in die Umgebung U₇, und entsprechend kann das Schleusentor 5b kürzer als das Schleusentor 5a ausgebildet sein.

Die Funktion einer Schleuse ist an sich bekannt, womit nur kurz darauf eingegangen zu werden braucht. Nachdem das Werkstück in der Umgebung U₀ auf den dahin ausgeschwenkten Hebel 11 aufgelegt worden ist, wird es damit durch das offene Schleusentor 5b ins Innere der Schleusenkammer 1 transportiert. Daraufhin wird das Schleusentor 5b gegen die Umgebung U₀ dichtend verschlossen und das Innenvolumen V₁ der Schleusenkammer 1 dann evakuiert und auf die in der Umgebung U₇ herrschenden Verhältnisse konditioniert, wenn verhindert werden muss, dass Verhältnisse der Umgebung U₀ nachmals auf die Verhältnisse in der Umgebung U₇ unerwünschten Einfluss nehmen. Andernfalls werden die bei offenem Schleusentor 5b im Inneren der Schleusenkammer eingetretenen Verhältnisse, entsprechend U₀, dort belassen. Darnach wird in jedem der beiden Fälle das Schleusentor 5a geöffnet und das Werkstück 13 mit dem Hebel 11 durch Weiterausschwenken in die Umgebung U₇ bzw. in die Behandlungskammer 7 transportiert.

Daraus ist ersichtlich, dass das Innenvolumen V₁ der Schleusenkammer dann, wenn eine Einflussnahme der Umgebung U₀ auf die Umgebung U₇ zu verhindern ist, evakuiert und konditioniert werden muss. Soll dabei auch, beispielsweise wegen der Giftigkeit der Umgebung U₇ verhindert werden, dass beim umgekehrten Zyklus die Umgebung U₇ auf die Umgebung U₀ Einfluss nimmt, so muss die Schleusenkammer 1, mit dem Innenvolumen V₁, bei Einbringen des Werkstückes 13 in U₇, dann Rückholen des Hebels 11 in die Umgebung U₀, zweimal evakuiert werden.

Wenn anderseits grundsätzlich eine gewisse Beeinflussung der Umgebung U₀ auf die Umgebung U₇ in Kauf genommen werden kann, allenfalls auch umgekehrt, so ist doch ersichtlich, dass für das Ausmass dieser Beeinflussung ebenfalls das Innenvolumen V₁ massgebend ist, indem dieses Volumen V₁, insbesondere mit Bezug auf das Volumen der Behandlungskammer 7, eine gewisse vorgegebene Grösse dann nicht überschreiten darf.

In allen Fällen ist somit anzustreben, das notwendige Volumen V₁ der Schleusenkammer 1 möglichst minimal zu halten und dabei trotzdem die erforderten Positionen in den beiden Umgebungen U₀ und U₇ ansteuern zu können.

Wie aus Fig. 1 ersichtlich, ist das Schleusenvolumen V₁ einerseits gegeben durch die dargestellte Aufrisskontur, nebst, selbstverständlich, ihrer Bauhöhe. Die Aufrisskontur aber bemisst sich bei in die Kammer 1 eingefahrener Hebelposition nach der maximalen azimutalen Ausdehnung αₒ des Hebels 11 bzw. des Werkstückes 13, wenn letzteres den Hebel 11 überkragt. Der mögliche Transportweg hingegen ist von der radialen Länge lₒ des Hebels 11 abhängig, womit das Volumen der Schleusenkammer 1 weitgehend unabhängig von der zu durchlaufenden Transportbahn ausgelegt werden kann, durch Minimalisierung von αₒ bei erforderlicher Länge lₒ.

In Fig. 2 ist dargestellt, wie eine Minimalisierung des Schleusenkammervolumens erreicht wird, obwohl in manchen Fällen das Minimum nicht erforderlich sein wird. Wenn, wie bereits in Fig. 1 dargestellt, der Hebel 11 wiederum schwenkbar um die Achse 9 in einer Schleusenkammer 1a schwenkbar gelagert, kreissektorförmig ausgebildet ist, so wird der Grundriss der Kammer 1a ebenfalls kreissektorförmig ausgebildet, indem die beiden Schleusentore 5a und 5b im wesentlichen entsprechend der Form des Hebels 11 angeordnet werden, somit hier im wesentlichen parallel zu den Schenkeln des Kreissektors. Müssen, wie gestrichelt bei 13a dargestellt, Werkstücke von der Umgebung U₀ nach der Umgebung U₇ oder umgekehrt transportiert werden, welche die azimutale Ausdehnung des Hebels 11 überragen, so muss selbstverständlich, wie bei 5a' dargestellt, die Form der Schleusenkammer 1a dem Rechnung tragen.

In Fig. 3 ist eine Schleusenkammeranordnung mit zwei erfindungsgemässen Schleusenkammern 20 und 22 dargestellt. Die jeweiligen Wandungen 21 bzw. 23 der Schleusenkammern weisen Schleusentore 21a, 21b bzw. 22a und 22b auf, so dass die beiden Schleusentore 21a und 22a das Innere der Schleusenkammern 20 bzw. 22 gegen die Umgebung U₀ dichtend verschliessen, die Schleusentore 21b bzw. 22b gegen die Umgebung U₇ innerhalb der Behandlungskammer 7.

Beide Schleusenkammern 20, 22 weisen als Transporteinrichtung wiederum einen um eine jeweilige Achse 25 bzw. 27 drehbaren Hebel 29 bzw. 30 auf. Entsprechend dem erwünschten Ausschwenkmass gemäss den Bahnen K₂₀ bzw. K₂₂ sind auch die jeweiligen Schleusentore dimensioniert. Wie aus Fig. 3 ersichtlich, sind die beiden Schleusenkammern 20 bzw. 22, mit der Anordnung ihrer Schwenkachsen 25, 27, der Längen ihrer Hebel 29, 30 sowie den vorgesehenen Schwenkwinkeln so angelegt, dass sich die überstrichenen Kreisflächen K₂₀ bzw. K₂₂, wie bei P₁ eingetragen, überlappen. Beispielsweise ist dieser Ueberlappungsbereich P₁ in Fig. 3 innerhalb der Behandlungskammer 7 vorgesehen, derart, dass z.B. mit dem Hebel 29 ein Werkstück von einer Aufnahmeposition P₂ in der Umgebung U₀ in die Behandlungsposition P₁ in der Behandlungskammer 7 gefördert werden kann und, nach entsprechender Behandlung, durch den Hebel 30 aufgenommen und in die Entnahmeposition P₃ in der Umgebung U₀ gefördert werden kann. Dabei können selbstverständlich die beiden Positionen P₂ und P₃ in zwei unterschiedlichen Umgebungen liegen und entsprechend die Schleusenkammern 20 bzw. 22 drei unterschiedliche Umgebungen trennen, so dass das Werkstück von P₂ in der einen Umgebung zu P₁ in der zweiten, dann zu P₃ in einer dritten Umgebung gefördert wird.

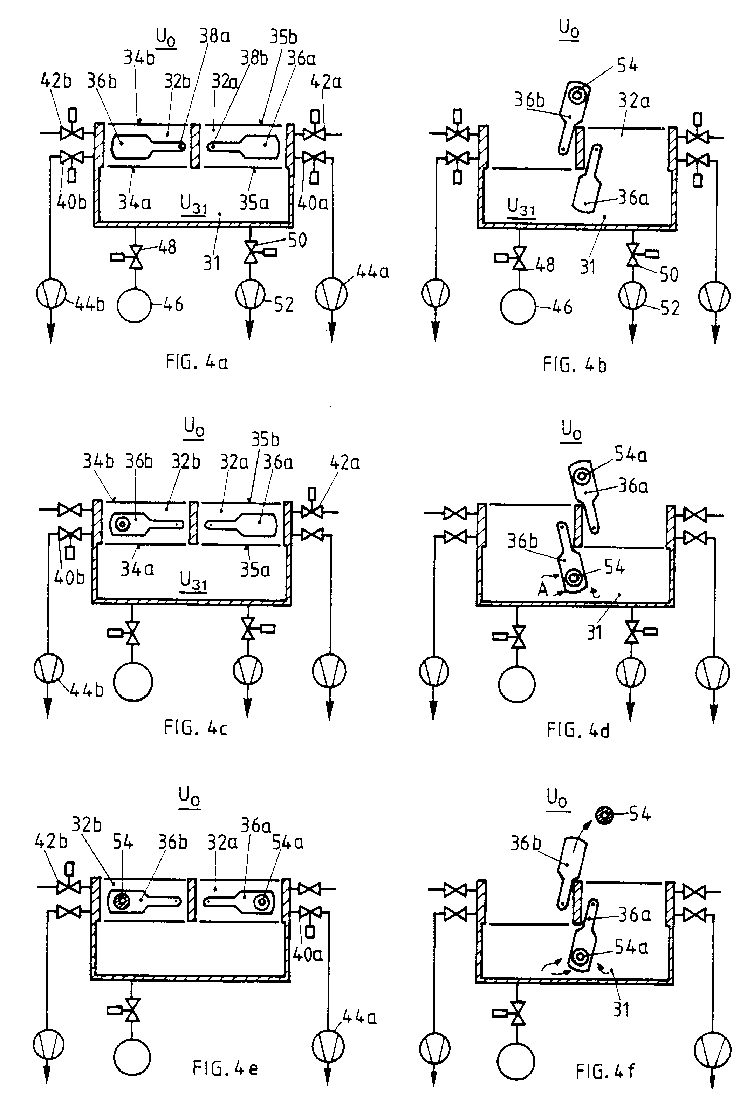

In Fig. 4a-f ist eine erfindungsgemässe Vakuumkammer mit einer erfindungsgemässen Schleusenkammeranordnung dargestellt, für das Aufbringen der Reflexionsschicht auf den Kunststoffgrundkörper von Compact Discs, als Werkstücke, in der genannten Vakuumkammer als Behandlungskammer. An einer Vakuumkammer 31 sind zwei erfindungsgemässe Schleusenkammern 32a und 32b vorgesehen. Beide Kammern 32 weisen je ein Paar Schleusentore 34a, 34b bzw. 35a, 35b auf. Als Schleusentore 34, 35, ebenso als Schleusentore in den vorgängig beschriebenen Ausführungsbeispielen, werden bevorzugterweise sog. Schlitzventile der Firma V.A.T. eingesetzt. Durch die beiden Schleusenkammern 32 wird die Vakuumkammerumgebung U₃₁ von der Aussenumgebung U₀ abgeschottet.

In den beiden Schleusenkammern 32 ist je ein löffelförmiger Transporthebel 36a bzw. 36b an entsprechenden Drehachsen 38a bzw. 38b schwenkbar gelagert, wobei die Schwenkachsen 38 einander benachbart angeordnet sind. Jede der beiden Schleusenkammern 32 weist ein Evakuierungsventil 40a bzw. 40b auf sowie ein gegen die Umgebung geführtes Ventil 42a bzw. 42b. Die den Evakuierungsventilen 40 zugeordneten Leitungen führen je auf Vakuumquellen 44a bzw. 44b.

Im weiteren ist für den hier betrachteten Vakuumabscheidungsprozess in der Vakuumkammer 31 ein Argontank 46 vorgesehen und über ein steuerbares Ventil 48 mit der Vakuumkammer 31 verbunden. Um die Vakuumkammer 31 zu evakuieren, ist eine Vakuumquelle 52 über ein Ventil 50 mit ihr verbunden.

Anhand der Fig. 4a bis f soll nun die Betriebsweise einer derartigen erfindungsgemässen Vakuumkammer 31 mit den erfindungsgemässen Schleusenkammern 32 erläutert werden.

In Fig. 4a ist die Ausgangslage der Kammer 31 dargestellt. Die Schleusenkammer 32a ist beidseits mit den Schlitzventilen 35a bzw. 35b geschlossen. Das Schlitzventil 34a der Kammer 32b ist ebenfalls geschlossen, das Schlitzventil 34b offen oder geschlossen, in Fig. 4a geschlossen dargestellt.

Durch Oeffnen des Ventils 50 und Betätigen der Vakuumquelle 52 wird die Vakuumkammer 31 evakuiert und über das Ventil 48 aus dem Argontank 46 auf die benötigte Argonatmosphäre konditioniert. Gleichzeitig wird über das Evakuierungsventil 40a die rechte Schleusenkammer 32a evakuiert. Die beiden noch leeren Transporthebel 36 liegen innerhalb der Schleusenkammern 32.

Nun wird, gemäss Fig. 4b, nach Schliessen der Ventile 48 und 50, Stillsetzen der Vakuumquelle 52, das Schlitzventil 35a der rechten Schleusenkammer 32a, wie dargestellt, geöffnet und der Transporthebel 36a, noch ohne Werkstück, in die Vakuumkammer 31 eingeschwenkt. Gleichzeitig wird, nach allfälligem Oeffnen des Schlitzventils 34b, der Transporthebel 36b in die Umgebung U₀ geschwenkt, wo er eine noch unbeschichtete Memory Disc, wie Compact Disc 54 aufnimmt.

Gemäss Fig. 4c wird darnach der Hebel 36b in seine Schleusenkammer 32b rückgeschwenkt, gleichzeitig der Hebel 36a in seine Schleusenkammer 32a, wonach alle Schlitzventile 35a,b bzw. 34a,b geschlossen werden. Nun wird mittels der Vakuumquelle 44b, nach Oeffnen des Ventils 40b, die linke Schleusenkammer 32b evakuiert, gleichzeitig, durch Oeffnen des Ventils 42a, die rechte Schleusenkammer 32a auf Umgebungsdruck entsprechend U₀ gelegt.

Darnach wird, übergehend auf die Konfiguration gemäss Fig. 4d, das Schlitzventil 34a geöffnet, ebenso das Schlitzventil 35b, und einerseits der mit der noch unbeschichteten Disc 54 beladene Transporthebel 36b in die Vakuumkammer 31 eingeschwenkt, anderseits der noch unbeladene Transporthebel 36a in die Umgebung U₀ ausgeschwenkt. Wie bereits ersichtlich, nimmt dabei die Aufnahmepartie des löffelförmigen Hebels 36a dieselbe Aufnahmeposition ein, die vorgängig gemäss Fig. 4b die Aufnahmepartie des löffelförmigen Transporthebels 36b eingenommen hatte.

Nun wird die noch unbeschichtete Disc 54, beispielsweise durch Aluminiumlegierungs-Vakuumabscheidung, wie mit A schematisch dargestellt, in der Vakuumkammer 31 behandelt. Gleichzeitig wird durch einen im Zusammenhang mit der vorliegenden Erfindung nicht interessierenden Beladeapparat dem Transporthebel 36a eine weitere unbeschichtete Disc 54a aufgelegt. Darnach schwenken die beiden Transporthebel 36 wiederum zurück in die in Fig. 4e dargestellte Lage. Dabei trägt der Hebel 36b die beschichtete Disc 54, während der Hebel 36a die noch zu behandelnde Disc 54a trägt.

Es werden nun gemäss Fig. 4e alle Schlitzventile geschlossen, die linke Schleusenkammer 32b durch Oeffnen des Ventils 42b auf Umgebungsdruck entsprechend der Umgebung U₀ gelegt. Gleichzeitig wird durch Oeffnen des Ventils 40a und Betätigen der Vakuumquelle 44a die rechte Schleusenkammer 32a evakuiert. Nun wird, übergehend in die Konfiguration gemäss Fig. 4f, der linke Transporthebel 36b in die Umgebung U₀, d.h. die Entnahmeposition für die beschichtete Disc 54, gebracht, welche auch die Aufnahmeposition für die jeweils zu beschichtenden Discs ist, wie der Quervergleich von Fig. 4f, 4d und 4b zeigt: Beide Hebel 36 nehmen an derselben Position in der Umgebung U₀ jeweils zu beschichtende Discs auf und geben sie dort auch wieder ab.

Rückkommend auf Fig. 4f wird gleichzeitig mit Oeffnen des Schlitzventils 34b das Schlitzventil 35a der rechten Schleusenkammer 32a geöffnet und der rechte Transporthebel 36a zur Behandlung der Disc 54a in die Vakuumkammer 31 eingeschwenkt.

Auch die Behandlungspositionen für die zu beschichtenden Discs, wie CD's, in der Vakuumkammer 31 sind für beide Transporthebel 36, wie der erwähnte Quervergleich zeigt, dieselben.

Nun läuft das Disc-Beschichtungsverfahren zyklisch weiter, d.h. es nimmt während der Beschichtung der Disc 54a der Hebel 36b eine neu zu beschichtende Disc auf etc.

In den Fig. 4b bis 4f wurden jeweils nur die bei ihrer Beschreibung aufgeführten Bezugszeichen eingesetzt, die übrigen ergeben sich aus der Darstellung von Fig. 4a. Es versteht sich von selbst, dass die Argonatmosphäre in der Vakuumkammer 31 konstant gehalten wird, und es ist ohne weiteres ersichtlich, dass, erfindungsgemäss, beide Schleusenkammern 32 auf minimales Volumen dimensioniert sind, so dass die jeweiligen Evakuierungen mit den Vakuumquellen 44a bzw. 44b (Fig. 4a) mit kleinstmöglichem Aufwand und in möglichst kurzen Zeiten durchführbar sind und sich auch nur minimale Aenderungen der Atmosphäre U₃₁ ergeben, wenn jeweils eine evakuierte Schleusenkammer 32 zur Kammer 31 hin geöffnet wird.

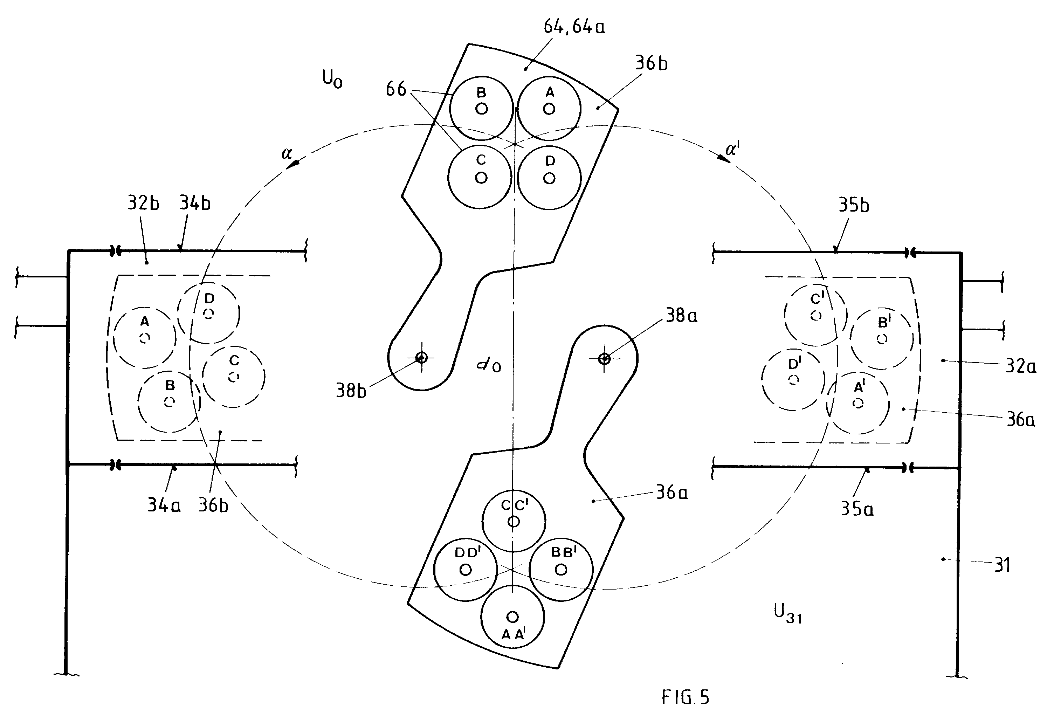

In Fig. 5 ist, wiederum in Aufsicht und schematisch, eine erfindungsgemässe Schleusenkammeranordnung in Analogie zu der in Fig. 4 dargestellten gezeigt. Es sind dieselben Positionsnummern wie in Fig. 4 verwendet. Die zwischen der Umgebung U₀ und der Behandlungskammer 31 zu fördernden Werkstücke 64 bzw. 64a, in Analogie zu den Discs 54 bzw. 54a von Fig. 4, umfassen hier jeweils vier Discs 66, welche vier Discs gemeinsam ein Werkstück im Sinne der vorliegenden Erfindung bilden. Bei der Anordnung gemäss Fig. 5 ist die Länge der Hebel 36a und 36b, der Abstand d₀ ihrer Schwenkachsen 38a bzw. 38b sowie das Ausmass des Schwenkwinkels α bzw. α' von einer gemeinsamen Position in der Umgebung U₀ in eine gemeinsame Position in der Umgebung U₃₁ so, dass sowohl in der Umgebung U₀ wie auch und insbesondere in der Umgebung 31, der Behandlungsumgebung, die jeweils durch die beiden Hebel hingeförderten bzw. aufgenommenen Werkstücke 64 mit derselben Ausrichtung zu liegen kommen. Werden auf den ausgezogen dargestellten Hebel 36b die Discs 66, die in der Umgebung U₀ aufgenommen werden, zur Verfolgung ihrer Bahn mit A, B, C, D bezeichnet, so ist ersichtlich, dass sie, über die gestrichelt dargestellte Position in der Schleusenkammer 32b, schliesslich in die wiederum ausgezogene Position A, B, C, D in der Umgebung U₃₁ eingeführt werden (s. Bahn α). Werden anderseits mit dem Hebel 36a, wie er ausgezogen in Fig. 5 in der Umgebung U₃₁ eingezeichnet ist, in der Umgebung U₀ mit derselben Ausrichtung die Discs 66, entsprechend mit A', B', C' und D' bezeichnet, aufgenommen, so werden sie bei Schwenken dieses Hebels 36a, entsprechend Bahn α', mit derselben Ausrichtung, wie vorgängig durch den Hebel 36b, in der Umgebung U₃₁ in die Positionen A', B', C' und D' gebracht. Diese sind, wie ersichtlich, identisch mit den Positionen A, B, C, D in der Umgebung U₃₁. Dies hat bei gewissen Behandlungsprozessen, wie der Vakuumbeschichtung von Discs, den wesentlichen Vorteil, dass bei der Beschickung durch beide Hebel dieselben Verhältnisse in der Behandlungskammer 31 gültig werden.

## Patentansprüche

1. Transporteinrichtung, um ein Werkstück aus einer ersten Umgebung in eine zweite zur fördern, im wesentlichen, ohne dass die eine Umgebung (U₀, U₇) die andere beeinflusste, mit einer Schleusenkammer, die die Umgebungen trennt und worin mindestens eine einseitig schwenkgelagerte Transporthebelanordnung (11; 29, 30; 36) vorgesehen ist, wobei die Schleusenkammer beidseits des Schwenklagers (9; 25, 27; 38) für die Hebelanordnung sich gegenüberliegende, zur Achse des Schwenklagers parallele Schleusentore (5; 21, 22; 34, 35) aufweist, derart, dass die Hebelanordnung zu beiden Umgebungen hin mit einer dem Schwenklager abgekehrten Partie, bei jeweils einem geöffneten Schleusentor, aus der Schleusenkammer ausschwenkbar ist, dadurch gekennzeichnet, dass die Hebelanordnung durch einen einarmigen, einseitig schwenkgelagerten Hebel (11; 29, 30; 36a, 36b) gebildet ist und das Schwenklager (9; 25, 27; 38a, 38b), betrachtet in Achsrichtung, zwischen den Schleusentoren im Bereich des Randes der Schleusenkammer angeordnet ist.

2. Transporteinrichtung nach Anspruch 1, dadurch gekennzeichnet, dass die Schleusentore durch Schiebeventile gebildet sind.

3. Transporteinrichtung nach Anspruch 2, dadurch gekennzeichnet, dass die Schiebeventile durch Schlitzschieber gebildet sind.

4. Transporteinrichtung nach einem der Ansprüche 1 bis 3, dadurch gekennzeichnet, dass mindestens ein Paar von Schleusenkammern (20, 22; 32a,b) vorgesehen ist und eine Steuerung, die die Schleusentore und die Hebel bezüglich der beiden Umgebungen (U₀, U₇; U₀, U₃₁) gegentaktig ansteuern.

5. Transporteinrichtung nach einem der Ansprüche 1 bis 3, dadurch gekennzeichnet, dass mindestens ein Paar von Schleusenkammern vorgesehen ist und sich die durch die Hebel (29, 30; 36a,b) überstrichenen Kreisbahnflächen (K) mindestens in der einen der Umgebungen (U₀, U₇; U₀, U₃₁) überlappen, derart, dass beide Transporthebel in dieser Umgebung in denselben Bereich wirken.

6. Transporteinrichtung nach einem der Ansprüche 4 oder 5, dadurch gekennzeichnet, dass sich die durch die Hebel überstrichenen Kreisbahnflächen in beiden Umgebungen (U₀, U₃₁) überlappen, derart, dass beide Transporthebel in beiden Umgebungen in je denselben Bereich wirken.

7. Transporteinrichtung nach einem der Ansprüche 4 bis 6, dadurch gekennzeichnet, dass die beiden Schleusenkammern (32a,b) so aneinanderliegen, dass ihre Schwenklager (38a,b) einander benachbart sind.

8. Transporteinrichtung nach einem der Ansprüche 4 bis 7, dadurch gekennzeichnet, dass die Hebel so angeordnet und deren jeweilige Schwenkwinkel so ausgebildet sind, dass je durch die Hebel in die eine der Umgebungen geförderte Werkstücke dort in gleiche absolute Ausrichtung bringbar sind und vorzugsweise in der anderen Umgebung von beiden Hebeln in einer gleichen absoluten Ausrichtung aufnehmbar sind.

9. Vakuumkammer mit mindestens einer Transporteinrichtung nach einem der Ansprüche 1 bis 8, wobei das Innenvolumen der Vakuumkammer die eine der Umgebungen bildet.

10. Verwendung der Transporteinrichtung nach einem der Ansprüche 1 bis 8 oder der Vakuumkammer nach Anspruch 9 für den Transport von Scheiben zwischen Bearbeitungsumgebungen, wobei der oder die Hebel einen löffelförmig dem Schwenklager abgekehrten Trägerteil für die Scheiben umfassen.

11. Verwendung nach Anspruch 10 für den Transport von Memory-Disk-Rohlingen.

12. Verwendung nach Anspruch 10 oder 11 für den Transport zwischen Vakuumbearbeitungsumgebungen.

13. Verfahren zum Beschicken und Entleeren einer Kammer mit vorgegebener Kammeratmosphäre mit Werkstücken aus bzw. in eine Umgebungsatmosphäre unter Verwendung einer Transporteinrichtung nach einem der Ansprüche 1 bis 8, dadurch gekennzeichnet, dass man
a) mindestens zwei Schleusenkammern (32a, 32b) parallel zueinander zwischen der Kammer (31) und der Umgebung (U₀) vorsieht,
b) die eine Schleusenkammer (32a) auf mindestens nahezu Kammeratmosphäre (U₃₁) bringt, die andere (32b) auf mindestens nahezu Umgebungsatmosphäre (U₀),
c) die eine Schleusenkammer (32a) mit der Kammer (31) verbindet, die andere (32b) mit der Umgebung,
d) mittels der jeweiligen Hebelanordnung je eine Transportoperation an Werkstücken gleichzeitig zwischen jeder der Schleusenkammern (32a, 32b) und der Kammer (31) einerseits bzw. der Umgebung (U₀) anderseits durchführt,
e) danach ein Werkstück aus der Kammer (31) in die eine Schleusenkammer (32a) einholt, letztere abkapselt und beide Schleusenkammern nun auf die jeweils anderen Atmosphären bringt,
f) die Schritte (c-e) zyklisch wiederholt.

## Claims

1. A conveying device for conveying a workpiece out of a first environment into a second environment, substantially without one environment (U₀, U₇) influencing the other, with a lock chamber separating the environments and containing at least one conveying lever arrangement (11 ; 29, 30 ; 36) pivotally mounted at one end, wherein on either side of pivot bearing (9 ; 25, 27 ; 38) for the lever arrangement the lock chamber has opposing lock gates (5 ; 21, 22 ; 34, 35) extending parallel to the axis of said pivot bearing, such that when the respective lock gates are open in turn, said lever arrangement can swing out of the lock chamber toward both environments with a part opposite to the pivot bearing, characterised in that the lever arrangement is formed by a one-armed lever (11 ; 29, 30 ; 36a, 36b) pivotally mounted at one end, and the pivot bearing (9 ; 25, 27 ; 38a, 38b), considered in axial direction, is provided between the lock gates in the region of the edge of the lock chamber.

2. A conveying device according to claim 1, characterised in that the lock gates are formed by slide valves.

3. A conveying device according to claim 2, characterised in that the slide valves are formed by slot slide valves.

4. A conveying device according to any of claims 1 to 3, characterised in that there is provided at least one pair of lock chambers (20, 22 ; 32a, b) and a control system that operates the lock gates and the levers in an inverted way with respect to both environments (U₀, U₇ ; U₀, U₃₁).

5. A conveying device according to any of claims 1 to 3, characterised in that there is provided at least one pair of lock chambers and the circular path surfaces (K) swept by the levers (29, 30 ; 36a, b) overlap at least in one of the environments (U₀, U₇ ; U₀, U₃₁) such that both conveying levers act into the same region in this environment.

6. A conveying device according to claim 4 or 5, characterised in that the circular path surfaces swept by the levers overlap in both environments (U₀, U₃₁) such that both conveying levers act into the same region in both environments.

7. A conveying device according to any of claims 4 to 6, characterised in that both lock chambers (32a, b) are adjacent so that their pivot bearings (38a, b) are contiguous.

8. A conveying device according to any of claims 4 to 7, characterised in that the levers are arranged and their respective pivoting angles are realised so that workpieces conveyed by the levers into one environment can be placed therein with the same absolute orientation and can preferably be received in the other environment by both levers with the same absolute orientation.

9. A vacuum chamber with at least one conveying device according to any of claims 1 to 8, whereby the inner volume of the vacuum chamber forms one of the environments.

10. An application of the conveying device according to any of claims 1 to 8 or of the vacuum chamber according to claim 9 for conveying discs between two treatment environments, whereby the lever(s) has (have) a spoon-shaped carrier part opposed to the pivot bearing for said discs.

11. An application according to claim 10 for conveying memory disc blanks.

12. An application according to claim 10 or 11 for the conveying between vacuum treatment environments.

13. A process for loading and unloading workpieces in or out of a chamber with a predetermined chamber atmosphere from or into an environment atmosphere, using a conveying device according to any of claims 1 to 8,
characterised in that
a) there is provided at least two paralled lock chambers (32a, 32b) between the chamber (31) and the environment (U₀),
b) the chamber atmosphere (U₃₁) is generated at least approximately in one lock chamber (32a) and the environment atmosphere (U₀) is generated at least approximately in the other (32b),
c) one lock chamber (32a) is connected to the chamber (31) and the other (32b) to the environment,
d) by means of the corresponding lever arrangement a workpiece conveying operation is performed simultaneously between each of the lock chambers (32a, 32b) and the chamber (31) on one side and the environment (U₀) on the other side,
e) then a workpiece is brought out of the chamber (31) into one lock chamber (32a), the latter is isolated and the other atmosphere is generated respectively in both lock chambers, and
f) the steps (c-e) are repeated in a cyclic way.

## Revendications

1. Dispositif de transport pour amener une pièce à traiter d'un premier environnement à un second environnement pratiquement sans qu'un environnement (U₀, U₇) influence l'autre, comportant un sas qui sépare les environnements et dans lequel il est prévu au moins un dispositif de levier de transport (11 ; 29, 30 ; 36) monté pivotant unilatéralement, étant précisé que le sas comporte, des deux côtés du palier de pivotement (9 ; 25, 27 ; 38) prévu pour le dispositif de levier, des portes de sas (5 ; 21, 22 ; 34, 35) qui se font face et qui sont parallèles au palier de pivotement, de sorte que le dispositif de levier est apte à pivoter hors du sas en direction des deux environnements, avec une partie opposée au palier de pivotement, quand les portes de sas respectives sont ouvertes chacune leur tour, caractérisé en ce que le dispositif de levier est formé par un levier à un bras (11 ; 29, 30 ; 36a, 36b) monté pivotant unilatéralement, et le palier de pivotement (9 ; 25, 27 ; 38a, 38b), considéré dans le sens axial, est disposé dans la zone du bord du sas, entre les portes de sas.

2. Dispositif de transport selon la revendication 1, caractérisé en ce que les portes de sas sont formées par des soupapes à coulisse.

3. Dispositif de transport selon la revendication 2, caractérisé en ce que les soupapes à coulisse sont formées par des coulisseaux à fente.

4. Dispositif de transport selon l'une des revendications 1 à 3, caractérisé en ce qu'il est prévu au moins une paire de sas (20, 22 ; 32a, b) ainsi qu'une commande qui commande les portes de sas et les leviers d'une manière inversée par rapport aux deux environnements (U₀, U₇; U₀, U₃₁).

5. Dispositif de transport selon l'une des revendications 1 à 3, caractérisé en ce qu'il est prévu au moins une paire de sas, et les surfaces de trajectoire circulaire (K) balayées par les leviers (29, 30 ; 36a, b) se recouvrent au moins dans l'un des environnements (U₀, U₇ ; U₀, U₃₁), de telle sorte que les deux leviers de transport agissent vers la même zone dans cet environnement.

6. Dispositif de transport selon la revendication 4 ou 5, caractérisé en ce que les surfaces de trajectoire circulaire balayées par les leviers se recouvrent dans les deux environnements (U₀, U₃₁), de telle sorte que les deux leviers de transport agissent vers la même zone dans les deux environnements.

7. Dispositif de transport selon l'une des revendications 4 à 6, caractérisé en ce que les deux sas (32a, b) sont contigus de telle sorte que leurs paliers de pivotement (38a, b) sont voisins.

8. Dispositif de transport selon l'une des revendications 4 à 7, caractérisé en ce que les leviers sont disposés et leurs angles de pivotement respectifs sont conçus pour que des pièces amenées par les leviers dans l'un des environnements puissent être placées dans celui-ci suivant la même orientation absolue et puissent de préférence être reçues dans l'autre environnement par les deux leviers suivant une même orientation absolue.

9. Chambre à vide comportant au moins un dispositif de transport selon l'une des revendications 1 à 8, le volume intérieur de la chambre à vide définissant l'un des environnements.

10. Utilisation du dispositif de transport selon l'une des revendications 1 à 8 ou de la chambre à vide selon la revendication 9 pour le transport de disques entre des environnements de traitement, le ou les leviers comprenant un élément de support en forme de cuiller pour les disques qui est opposé au palier de pivotement.

11. Utilisation selon la revendication 10 pour le transport d'ébauches de disques de mémoires.

12. Utilisation selon la revendication 10 ou 11 pour le transport entre des environnements de traitement sous vide.

13. Procédé pour charger et décharger une chambre présentant une atmosphère de chambre prédéfinie avec des pièces à traiter, à partir d'une atmosphère d'environnement ou vers celle-ci, en utilisant un dispositif de transport selon l'une des revendications 1 à 8, caractérisé
a) en ce qu'on prévoit entre la chambre (31) et l'environnement (U₀) au moins deux sas (32a, 32b) parallèles,
b) en ce qu'on crée dans un sas (32a) au moins approximativement l'atmosphère de chambre (U₃₁) et dans l'autre (32b) au moins approximativement l'atmosphère d'environnement (U₀),
c) en ce qu'on relie un sas (32a) à la chambre (31) et l'autre (32b) à l'environnement,
d) en ce qu'on procède à l'aide du dispositif de levier correspondant à une opération de transport simultanée pour les pièces entre chacun des sas (32a, 32b) et la chambre (31), d'un côté, et l'environnement (U₀), de l'autre côté,
e) en ce qu'on amène ensuite une pièce de la chambre (31) vers un sas (32a), on isole celui-ci et on crée dans les deux sas l'autre atmosphère respective,
f) on reprend de façon cyclique les étapes (c-e).
